# EUROPEAN PATENT APPLICATION

(11) **EP 1 477 859 A1**
(43) Date of publication of application: **17.11.2004**
(21) Application number: 04011304.5
(22) Date of filing: 12.05.2004
(51) Int. Cl.: G03F 7/42, C11D 7/08, C11D 7/26, C11D 7/50, C08K 5/09

(54) **Composition for removal of sidewall polymer and etchant residues without a separate solvent rinse step**

(30) Priority: 14.05.2003 KR 2003030452
(71) Applicant: Liquid Technology Co., Ltd., Sungnam-Shi, Kyungki-Do (KR)
(72) Inventor: Kim, Sung, Jin, Anyang-Shi Kyungki-Do (KR)
(74) Representative: TER MEER STEINMEISTER & PARTNER GbR

(57) **Abstract**

The present invention provides a chemical composition for removing sidewall polymer or etchant residues produced and remaining from various etching, ashing and/or ion implantation processes during photo-processes of semiconductors, and denaturalized photo-sensitive metallic residues etched from a bottom metal layer, the chemical composition comprising: at least one organic acid forming coordinate bond with metals, wherein the organic acid is represented by following chemical formula (I) and (II), 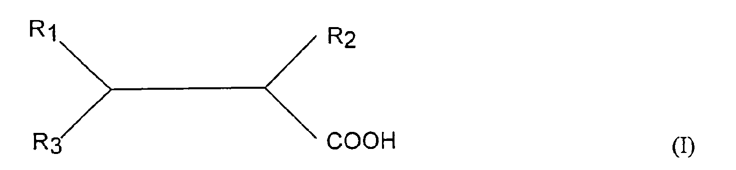 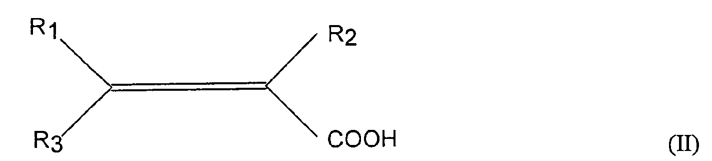 and R1, R2 and R3 is independently selected from a group consisted of hydrogen, alkyl, -OH(hydroxyl) and -COOH(carboxy) groups, and if the R3 is selected from -COOH group, the R3 forms anhydride with -COOH group among the No. 1 carbon atom; a polar organic solvent represented by RₙO(CH₂CH₂O)ₘH, wherein n and m is independently a constant of 2 to 10; an additional acid including oxalic acid or inorganic acid; and de-ionized water.

## Description

### BACKGROUND OF THE INVENTION

The present invention relates to a chemical composition for removing sidewall polymer or etchant residues produced and remaining from various etching, ashing and/or ion implantation processes during the photo-processing of semiconductors, and denaturalized photo-sensitive metallic residue etched from the bottom metal layer (hereafter collectively "residue(s)"). In essence, the chemical composition has several significant advantages when compared to conventional residue removal products, which includes but not limited to the followings: The chemical composition does not produce any corrosion or damage to the bottom layer and is economical due to less evaporation loss. The residue cleansing process using the chemical composition does not require separate solvent rinse step essential in conventional photo-processing. Moreover, the eco-friendly chemical composition is virtually non-toxic to the human body and is both applicable in aluminum as well as copper line processes.

Conventionally, the fabrication of semiconductors is comprised of a series of process steps to form a pattern of conductive metal layer on the substrate by applying a pattern of photo-resistive etchant-resistant mask on the conductive layer, which then the mask is used as a protection against various etchants applied to etch the conductive metal layer. The etchant-resistant mask must then be removed during the cleansing step following the formation of a desired pattern of conductive metal layer through an etching process.

Accordingly, various chemical compositions of organic amine compounds, specifically alkanol amines, such as monoethanol amines and various organic solvents, have been used in conventional wet cleansing process to remove residue. However, such conventional amine-based compositions does not satisfactorily remove residues denaturalized during the exposure to the plasma etching gas or ion beam used in the dry etching, ashing or ion implantation steps.

Notably, the recent evolution of semiconductor manufacturing process is rapidly evolving to a higher condensation, which requires the process of etchant-resistant mask at high temperatures ranging from 120 to 140°C, and in the case for dry etching and ashing, the process also requires high temperature, high pressure and a higher dose of plasma. Such severe process conditions usually become hindrance to the complete removal of residues, especially organometallic and metal oxide residues. Accordingly, the recently evolving semiconductor processes has been demanding for the development of new residue removal chemistry which may satisfactorily remove residues formed under high temperature, high pressure and high dose plasma process conditions.

For the satisfactory removal of residues formed under high temperature, high pressure and high dose plasma process conditions, several chemical compositions comprised of ① hydroxylamine, ② alkanol amines, ③ de-ionized water, with or without anticorrosion agent, have been introduced. For example, the Japanese published patents, No. 1992-28986, 1994-266119 and 1997-96911, disclose some of the compositions invented for the removal of such residues.

However, the hydroxylamine (HA)-based composition tends to display insufficient residue removal performance at process temperatures below 50 °C, which requires the composition to be applied at higher temperatures above 70 °C, which in turn, results in significant evaporation loss. In any case the evaporation loss exceeds over 10%, the residue removal performance capabilities of the composition are also significantly hindered. Moreover, the HA-based composition also requires a separate solvent rinse step to prevent any corrosion and changes in electrical characteristics of conductive bottom metal layer. Notably, the HA-based composition may not be used to remove residues in any case the metal layer is formed with copper, due to the highly corrosive nature of copper metal.

Hence, a strong demand has been arising for new chemical composition that may satisfactorily remove residues at process temperatures below 50 °C, results in less evaporation loss at high temperatures above 70 °C and exhibits an evaporation rate of less than 10% in spite of a prolonged use, as well as a composition that may be used in both aluminum and copper processes.

Accordingly, the main objective of the present invention is to introduce and offer a new chemical composition that may well solve the inherent problems of conventional chemical compositions and technologies available to successfully remove residues. The chemical composition introduced herein displays optimum performance in the removal of residues, especially the removal of organometallic and metal oxide residues, at the same time, does not corrode or damage the bottom metal layer, which allows the composition to be applied to both aluminum and newly-emerging copper metal processes. The new composition also exhibits lower evaporation rate and does not require a separate solvent rinse step, which in turn, provides a stable and economical cleansing process. Moreover, the eco-friendly composition is proven to be non-toxic to the human body and environmentally safe.

### SUMMARY OF THE INVENTION

In accordance with an aspect of the present invention, there is provided a chemical composition for removing sidewall polymer or etchant residues produced and remaining from various etching, ashing and/or ion implantation processes during photo-processes of semiconductors, and denaturalized photo-sensitive metallic residues etched from a bottom metal layer, the chemical composition comprising: at least one organic acid forming coordinate bond with metals, wherein the organic acid is represented by following chemical formula (I) and (II), 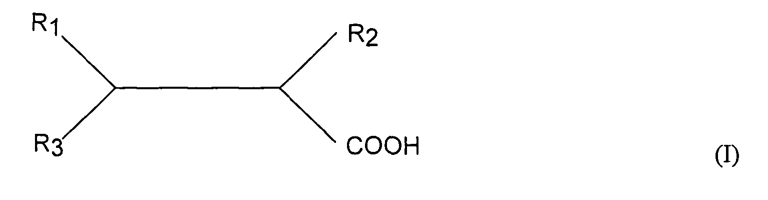 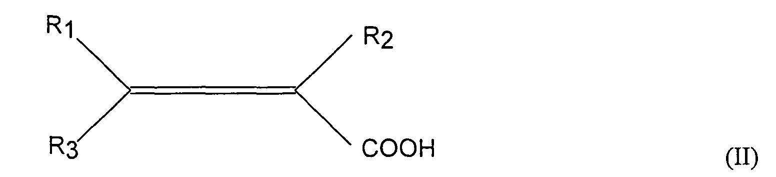 and R1, R2 and R3 is independently selected from a group consisted of hydrogen, alkyl, -OH(hydroxyl) and -COOH(carboxy) groups, and if the R3 is selected from -COOH group, the R3 forms anhydride with -COOH group among the No. 1 carbon atom; a polar organic solvent represented by RₙO(CH₂CH₂O)ₘH, wherein n and m is independently a constant of 2 to 10; an additional acid including oxalic acid or inorganic acid; and de-ionized water.

In accordance with another aspect of the present invention, there is provided a chemical composition for removing residues generated in processes for forming semiconductors, the chemical composition comprising: at least one organic acid forming coordinate bond with metals, wherein the organic acid is represented by following chemical formula (I) and (II), 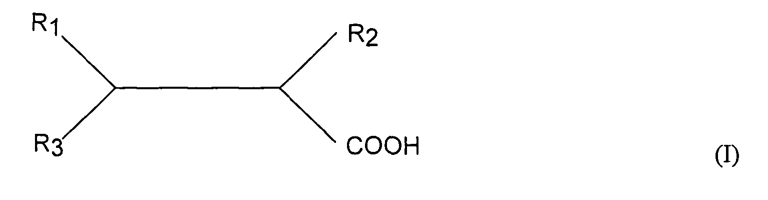 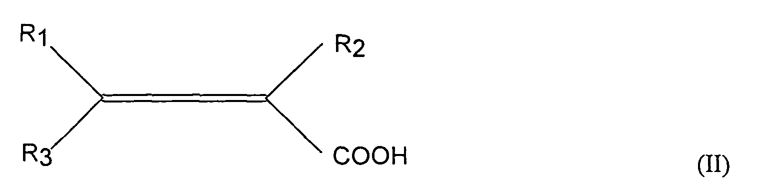 and wherein, R1, R2 and R3 is independently selected from a group consisted of hydrogen, alkyl, -OH(hydroxyl) and -COOH(carboxy) groups, and if the R3 is selected from -COOH group, the R3 forms anhydride with -COOH group among the No. 1 carbon atom; a polar organic solvent represented by RₙO(CH₂CH₂O)ₘH, wherein n and m is independently a constant of 2 to 10; an additional acid including oxalic acid or inorganic acid; and de-ionized water.

### DESCRIPTION OF THE DRAWINGS

FIG. 1 is a SEM photograph showing hole pattern before removing residue;
FIG. 2 is a SEM photograph showing hole pattern after removing residue with composition in Example 6;
FIG. 3 is a SEM photograph showing hole pattern after removing residue with composition of Comparative Example 1;
FIG. 4 is a SEM photograph showing surface of aluminum single layer before removing residue;
FIG. 5 is a SEM photograph showing surface of aluminum single layer after removing residue with composition in Example 6;
FIG. 6 is a SEM photograph showing surface of aluminum single layer after removing residue with composition of Comparative Example 7;
FIG. 7 is a SEM photograph showing surface of aluminum single layer after removing residue with composition of Comparative Example 8;
FIG. 8 is a SEM photograph showing surface of copper single layer before removing residue;
FIG. 9 is a SEM photograph showing surface of copper single layer after removing residue with composition in Example 6;
FIG. 10 is a SEM photograph showing surface of copper single layer after removing residue with composition of Comparative Example 7;
FIG. 11 is a SEM photograph showing surface of copper single layer after removing residue with composition of Comparative Example 8;
FIG. 12 is a graph representing evaporation losses of compositions in Example 6, and Comparative Example 7 and 8 at 70°C;
FIG. 13 is a SEM photograph showing metal line before removing residue;
FIG. 14 is a SEM photograph showing metal line after removing residue with composition in Example 6, which was kept at 70 °C for 72 hrs;
FIG. 15 is a SEM photograph showing metal line after removing residue with composition of Comparative Example 7, which was kept at 70 °C for 72 hrs; and
FIG. 16 is a SEM photograph showing metal line after removing residue with composition of Comparative Example 8, which was kept at 70 °C for 72 hrs.

### DESCRIPTION OF PREFERRED EMBODIMENTS

A chemical composition for the removal of sidewall polymer or etchant residues produced and remaining from various etching, ashing and/or ion implantation processes during the photo-processing of semiconductors, and denaturalized photo-sensitive metallic residue etched from the bottom metal layer, the chemical composition comprises one or two organic acid(s) that may form coordinate bond with metals and represented by following chemical formula (I) and (II), 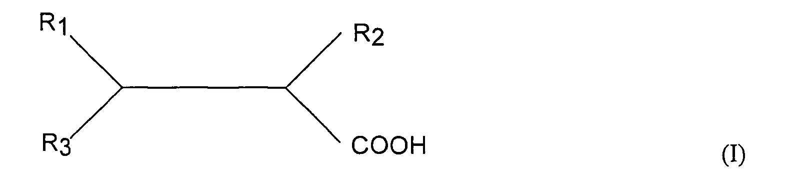 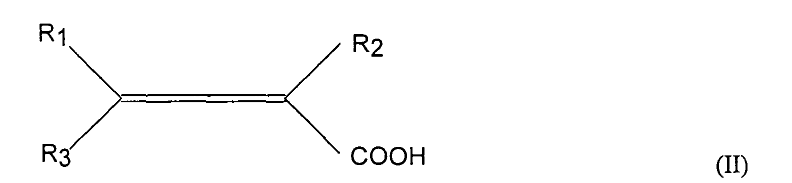 wherein, R1, R2 and R3 is independently selected from the group consisted of hydrogen, alkyl, -OH(hydroxyl) and -COOH(carboxy) groups, and if the R3 is selected from -COOH group, the R3 may form anhydride with -COOH group among the No. 1 carbon atom; polar organic solvent represented by the formula RₙO(CH₂CH₂O)ₘH, wherein, n and m is independently a constant of 2 to 10; additional acids comprised of oxalic acid or inorganic acid; and de-ionized water.

The chemical composition for removing residues in accordance to the present invention, the organic acid may be preferably selected from any of a group consisted of tartaric acid represented by the following chemical formula (III), citraconic acid represented by the following chemical formula (IV), citraconic anhydride represented by the following chemical formula (V), maleic acid(cis type) represented by the following chemical formula (VI), maleic anhydride represented by the following chemical formula (VII) or fumaric acid represented by the following chemical formula (VIII), which may be used in the range of 3.00 to 9.99% of total weight of the composition.

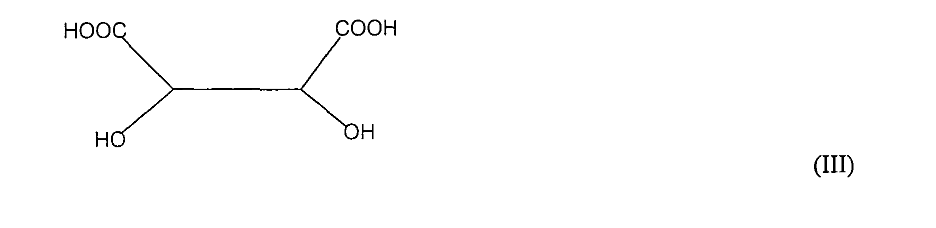

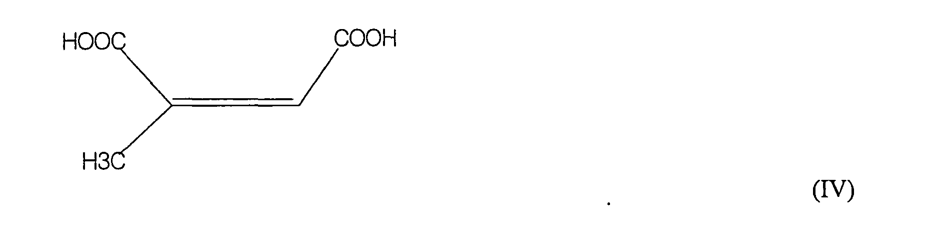

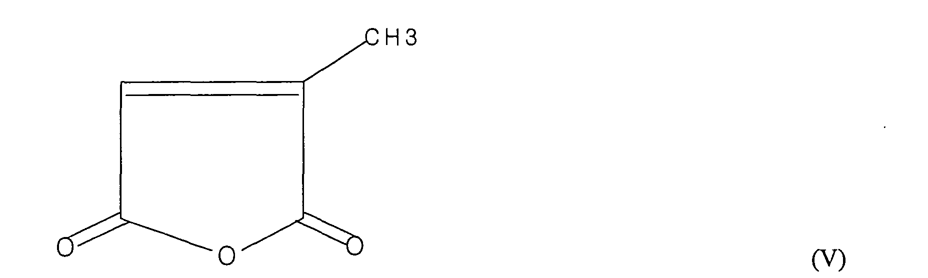

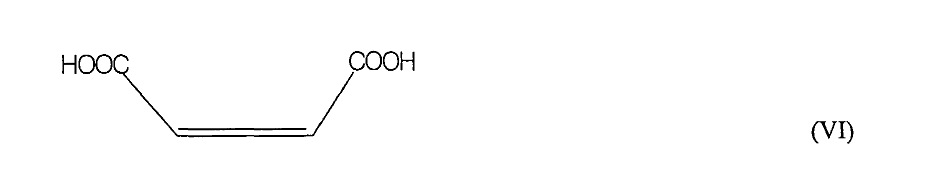

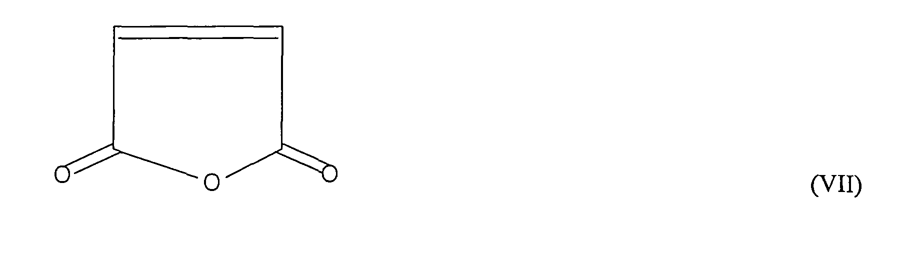

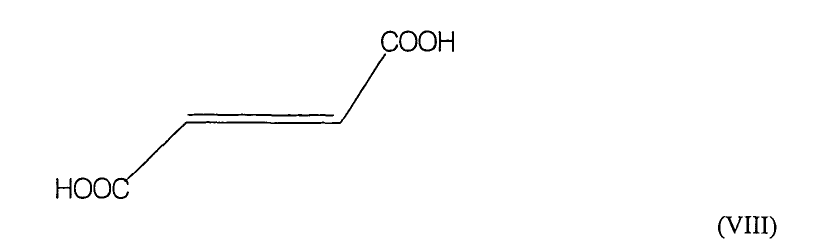

The organic acids represented by chemical formula (IV) to (VIII) have conjugated bond structure that generates less positive ions when compared to oxalic acid or citric acid, thus less corrosive to the bottom metal layers comprised of aluminum and copper metals and exhibits residue removal capabilities through electro-chemical reactions.

Moreover, the composition in accordance to the present invention preferably uses one or two mixed aqueous organic solvents selected from a group of methyl carbitol (MDG), ethyl carbitol (EDG), butyl carbitol (BDG), dimethyl carbitol (DMDG) or dibutyl carbitol (DBDG) as the polar organic solvents.

The carbitol-based polar organic solvents exhibits superior solubility to a photo-resistive etchant-resistant mask, successfully removing even a small amount of remaining mask that are not denaturalized during the dry etching and ashing processes. Furthermore, the carbitol-based polar organic solvents help to maintain the optimal residue removal performance of the composition by preventing evaporation loss of de-ionized water through hydrogen-bonding with water molecules. The carbitol-based polar organic solvents, which shares similar chemical structure with non-ionic surfactants, also help to easily remove residues on the surface of wafer through dispersion of foreign residues. The carbitol-based polar organic solvents may be used preferably in the range of 65.0 to 85.7 % of total weight of the composition.

Additional acids used in the composition for removing residues in accordance to the present invention may be comprised of more than one type of inorganic acid, which is selected from oxalic acid, phosphoric acid, perchloric acid and/or fluoric acid. By adding the above acids, the composition may provide enhanced residue removal capabilities. However, improper use and combination of acids and chemical weight composition may result in insufficient removal of residue and corrosion in the aluminum or copper layers. Preferably, the addition of the acids to the composition should be determined at the range between 0.05 to 0.50 % of total weight of the composition.

The lab examples of the present invention are presented below to provide better depictions of the present invention. However, the scope of the present invention is not restricted to the following examples.

### Examples

### Example 1

The composition according to the present invention was prepared by agitating a mixture of tartaric acid (5.00 wt%), dibutyl carbitol (75.00 wt%), oxalic acid (0.05 wt%) and de-ionized water (19.95 wt%) in a mixing vessel at room temperature until the solid materials are thoroughly mixed and completely dissolved into a uniform solution.

### Examples 2 to 12: Comparative Examples 1 to 6

The procedure described in Example 1 was repeated with various combinations of contents in the TABLE 1 respectively to prepare different combinations of compositions.

### Comparative Examples 7 and 8

EKC-270T™, commercially available from EKC, was used without any further alterations as Comparative Example 7 and ACT-935, commercially available from ACT, was used without any further alterations as Comparative Example 8. Both compositions are hydroxylamine-based compositions used to remove residues.

### Evaluation 1: Evaluation of substrate with Al-Cu bottom metal layer

The compositions for each example were tested and evaluated in a water bath maintained at constant temperature for over 30 minutes, after which the tests were conducted at different temperatures as indicated in TABLE 1.

Silicon wafers with bottom metal layers that are comprised of TiN/Al-Cu/TiN/Ti/oxide stack and treated with dry etching and ashing step in the conventional semiconductor fabrication process were used as the substrate for evaluation. The silicon wafers were dipped into each composition for given time at given temperature as indicated in TABLE 1, followed by a rinse step with flowing de-ionized water for 30 seconds and a dry step with dry air. Then, the wafers were observed using S-4500 scanning electron microscope (SEM) from Hitachi to photograph and determine the degree of residue removal and resulting corrosion on the metal surface.

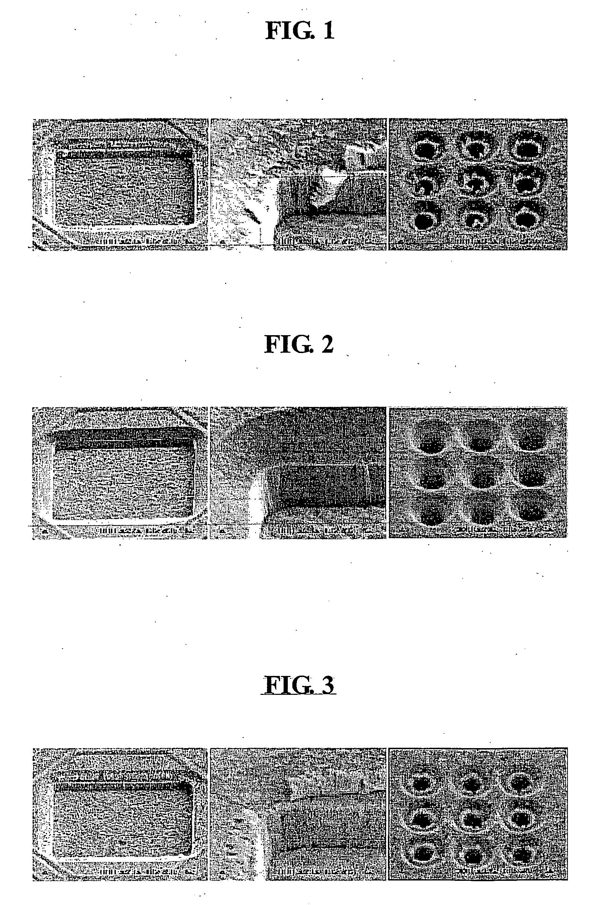

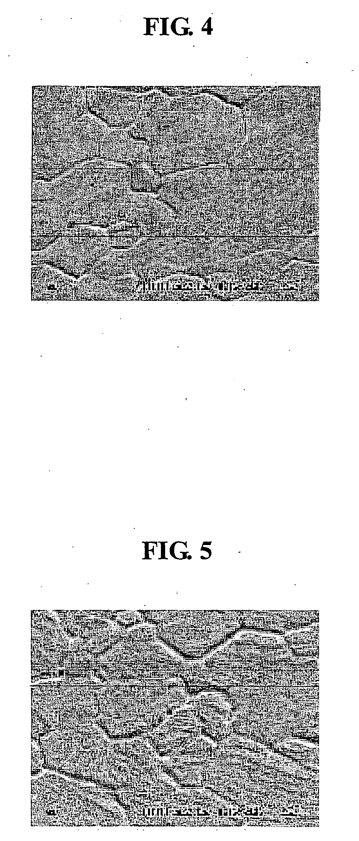

The SEM photograph of hole pattern before removing residues is given in FIG. 1, SEM photograph of hole pattern after removing residues using the composition of Example 6 is given in FIG. 2, and SEM photograph of hole pattern after removing residues using the composition of Comparative Example 1 is given in FIG. 3. When comparing FIG. 2 to FIG. 3, the composition of Example 6 in accordance to the present invention is shown to have better removed residues than when using the composition of

### Comparative Example 1.

The order of compositions shown in the TABLE 1 below is in the order of examples. The resulting degree of residue removal and corrosion were indicated in the increment of 10 grades with R1 as an indication of virtually no removal of residue and R10 as an indication of complete removal of residues. Similarly, C1 is an indication of a worst case of corrosion and C10 as showing no signs of corrosion.

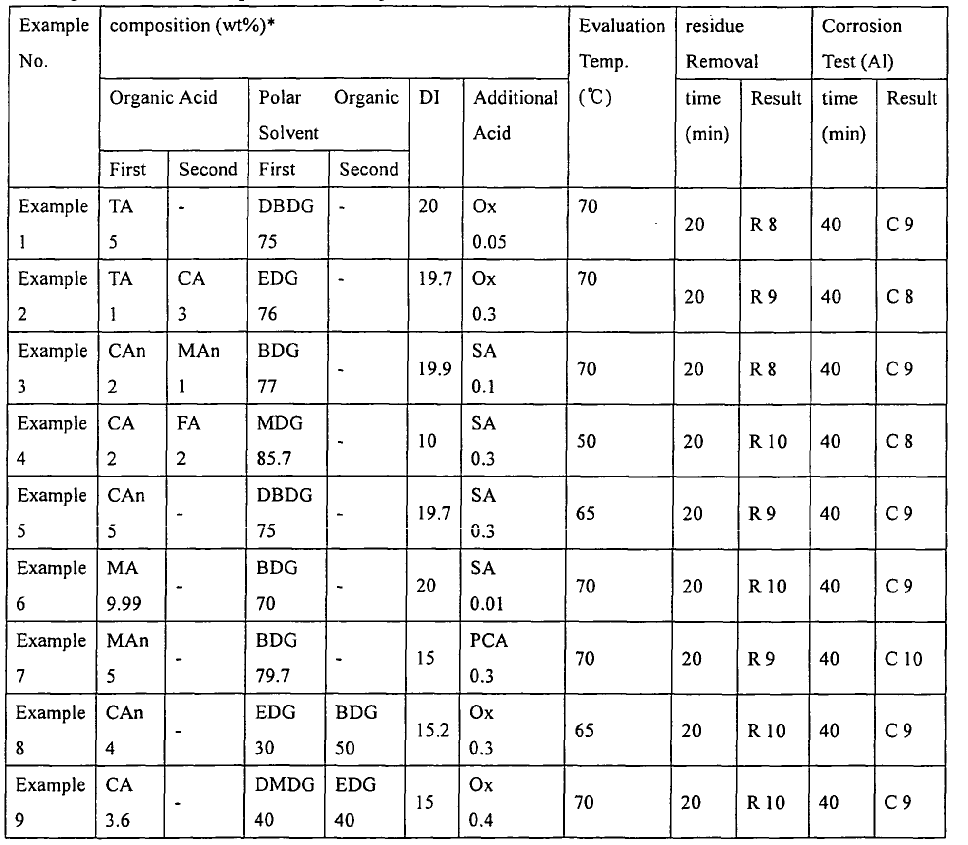

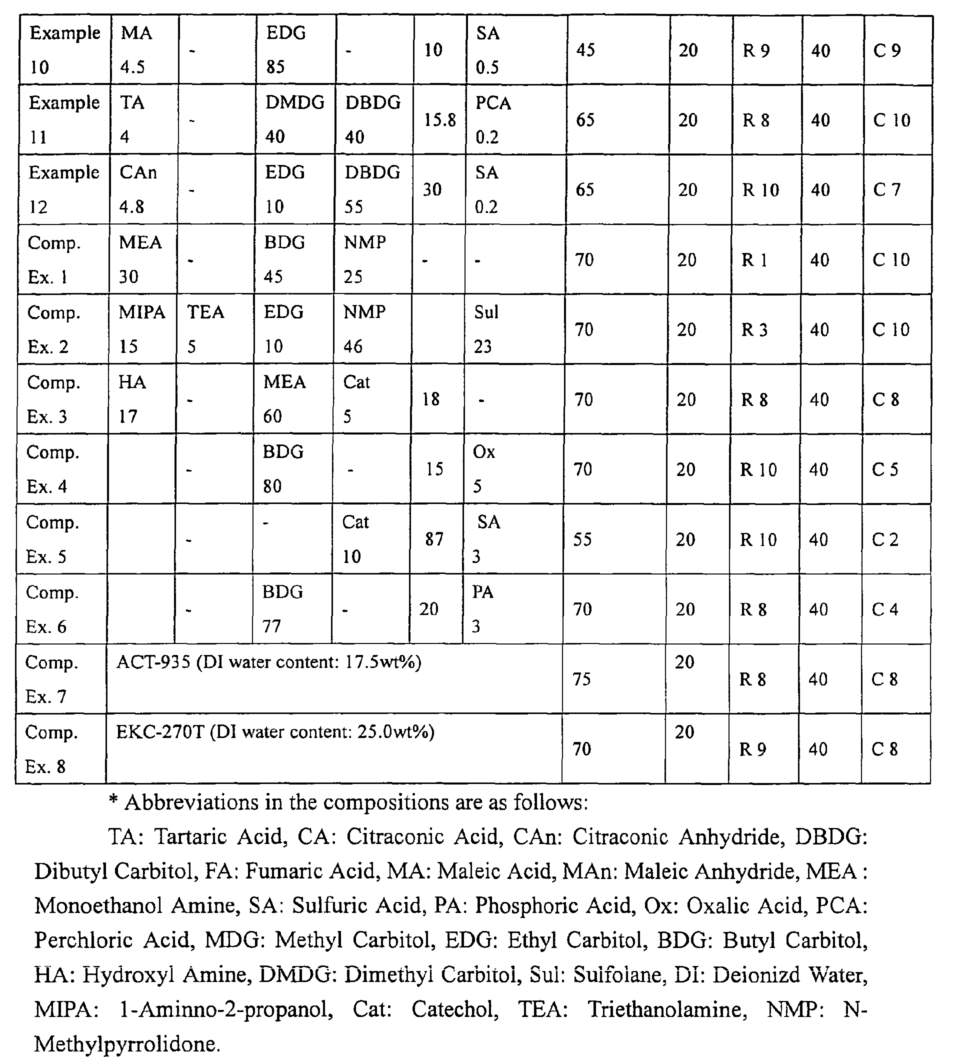

For the compositions for Comparative Example 1 through 6 in the TABLE 1 above, hydroxyl amines or alkanol amines are listed in the column titled 'Organic Acid'.

### Evaluation 2: Corrosion test for aluminum and copper single layer

For the corrosion test for aluminum and copper single layer, 10cm x 10cm specimens of Silicon wafer uniformly coated with aluminum and copper foil (purity 99.98%) commercially available from Aldrich were used for the corrosion test. The test was performed as follows:

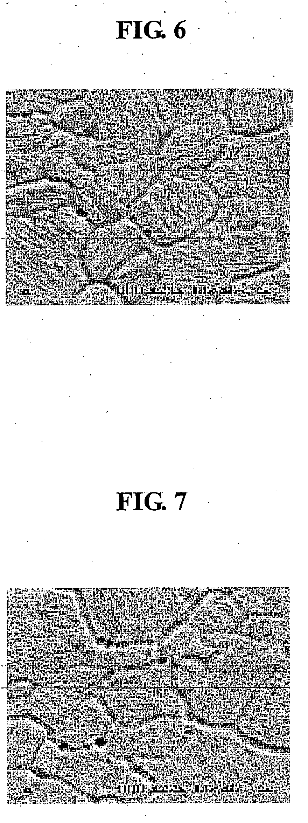

The specimens were charged into 50ml vials each containing 30g of the composition from Example 6, and competing compositions from Comparative Example 7(ACT-935, DI content: 17.5wt%) and Comparative Example 8 (EKC-270T, DI water content: 25.0wt%), respectively, kept for 3 hours in a hot air type drying oven, then rinsed with flowing de-ionized water for 30 seconds and dried with dry air, after which the surfaces of specimens were observed using scanning electron microscope. Fig. 4 is the depiction of a SEM photograph of aluminum single layer before any chemical treatment for removing residue, whereas Fig. 5 through 7 are respectively showing SEM photographs of aluminum single layer surface after treating each aluminum specimens with the compositions from Example 6, which is in accordance to the present invention, and competing compositions of comparative Examples 7 and 8. Referring to photographs depicted in the FIG. 5 through 7, the test results using the composition from the present invention in Example 6 is clearly showing significant reduction in corrosion on aluminum surface when compared to the results of tests using the compositions of the Comparative Examples 7 and 8.

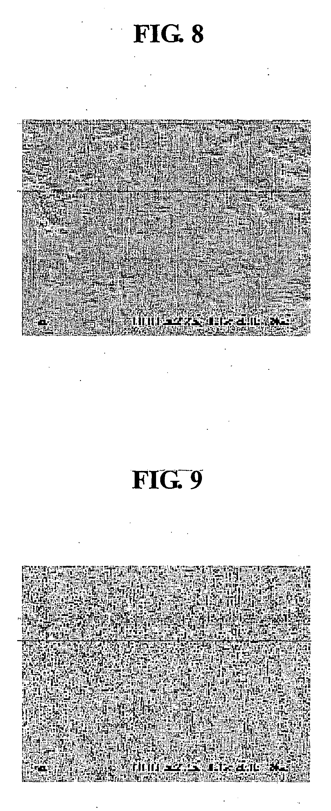

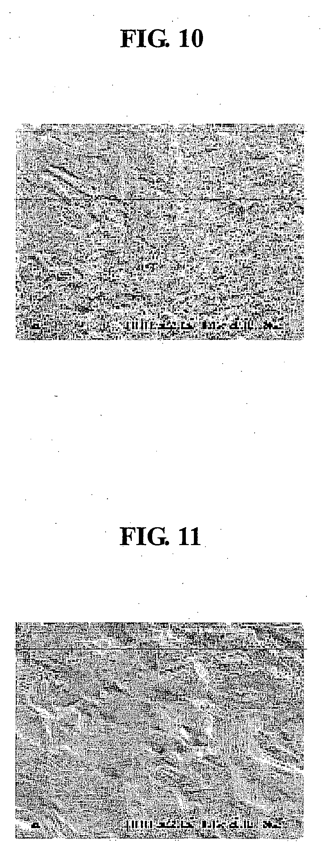

Similarly, Fig. 8 is the depiction of a SEM photograph of copper foil surface before any chemical treatment for removing residue, whereas Fig. 9 through 11 are respectively showing SEM photographs of copper foil surface after treating each copper specimens with the compositions from Example 6, which is in accordance to the present invention, and competing compositions of comparative Examples 7 and 8. Referring to photographs depicted in the FIG. 9 through 11, the test results using the composition from the present invention in Example 6 is clearly showing significant reduction in corrosion on copper surface when compared to the results of tests using the compositions of the Comparative Examples 7 and 8.

### Evaluation 3: Performance Evaluation of residue Removal Following Significant Evaporation Loss

The duration of prolonged use of a residue removal chemical composition is highly affected by the amount of evaporation loss and the performance of residue removal of the composition being used after a significant evaporation loss, which in turn, becomes an important measuring parameter for evaluating the stability and economy of the composition in question.

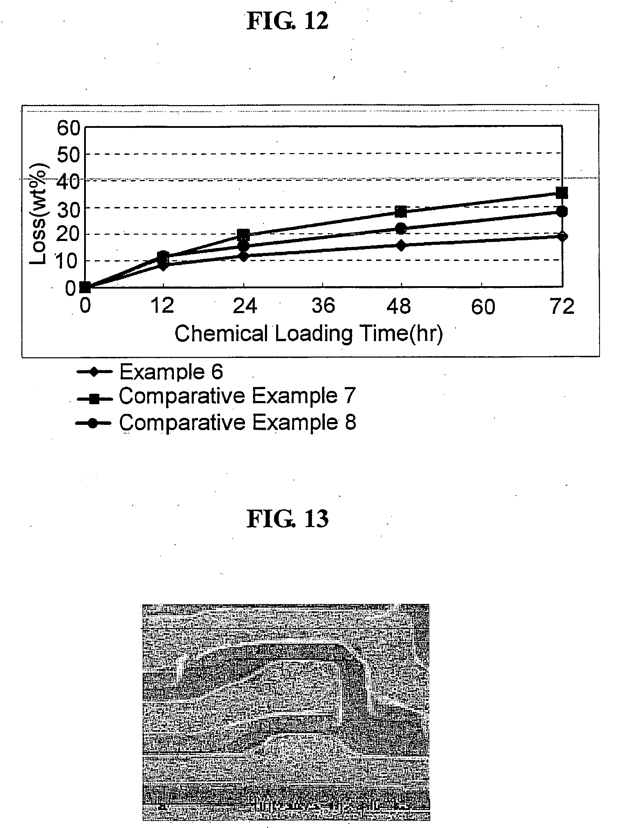

To compare the amount of evaporation loss and residue removal performance after a significant evaporation loss for the composition in Example 6 against competing compositions in Comparative Examples 7 and 8, 50g of each composition was poured into 100mL polyethylene bottles with only 10% of opening surface of the bottles exposed. Then, the bottles were placed in hot air type dry oven for 12, 24, 48 and 72 hours, respectively, after which the amount of evaporation loss were measured and the results depicted in Fig. 12. The residue removal performance after evaporation loss and the degree of corrosion were measured and recorded in Table 2.

As in FIG. 12, the evaporation loss of the composition of Example 6 is reduced to about 1/2 of the evaporation loss of the compositions of comparative Examples 7 and 8.

Moreover, the residue removal performance of the composition of Example 6 has shown no significant changes in performance even after experiencing an evaporation loss of 18.8% from 72 hours of exposure to hot air. In contrast, the residue removal performances of the compositions of Comparative Example 7 and 8 were drastically reduced after evaporation loss of over 10%.

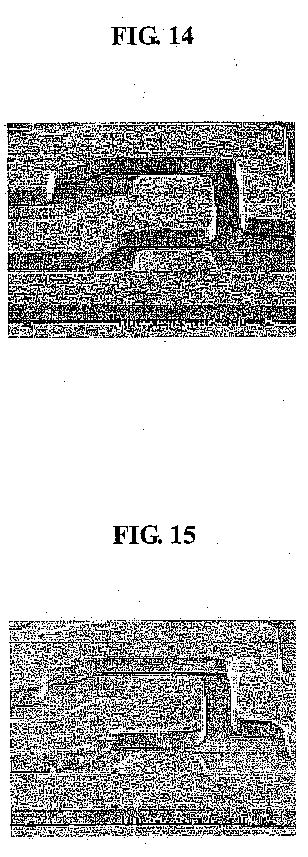

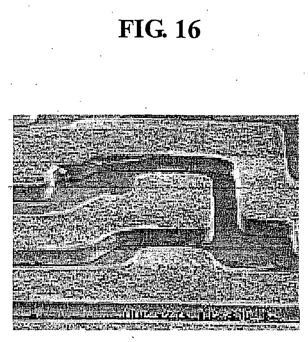

Fig. 13 is the depiction of a SEM photograph of metal line before any chemical treatment for removal of residue, whereas Fig. 14 through 16 are respectively showing SEM photographs of metal lines after placing each with the composition from Example 6, which is in accordance to the present invention, and competing compositions of comparative Examples 7 and 8 for 72 hours at 70°C. Referring to photographs depicted in the FIG. 14 through 16, the test results using the composition from the present invention in Example 6 is clearly showing superior residue removal performance capabilities despite significant evaporation loss when compared to the results of tests using the compositions of the Comparative Examples 7 and 8.

**TABLE 2**

| | | | | | | | |
|---|---|---|---|---|---|---|---|
| Results of Evaluation on residue Removal Performance Capability of residue Removal Chemical compositions Following a Significant Evaporation Loss | | | | | | | |

| Chemical composition | Evaporation time (hrs) | Loss (wt%) | Evaluation temp. (°C ) | residue Removal | | Corrosion test [Al] | |
|---|---|---|---|---|---|---|---|
| | | | | time [min] | Result | time [min] | Result |
| | 0 | 0 | 70 | 20 | R 10 | 40 | C 9 |
| | 12 | 8.4 | 70 | 20 | R 10 | 40 | C 9 |
| Example 6 | 24 | 11.8 | 70 | 20 | R10 | 40 | C 9 |
| | 48 | 15.6 | 70 | 20 | R 10 | 40 | C 9 |
| | 72 | 18.8 | 70 | 20 | R10 | 40 | C 9 |
| Comp. Ex. 7 | 0 | 0 | 75 | 20 | R 8 | 40 | C 9 |
| | 12 | 11.1 | 75 | 20 | R4 | 40 | C 9 |
| | 24 | 19.4 | 75 | 20 | R 3 | 40 | C 10 |
| | 48 | 28.0 | 75 | 20 | R 2 | 40 | C10 |
| | 72 | 35.0 | 75 | 20 | R2 | 40 | C 10 |
| | 0 | 0 | 70 | 20 | R 9 | 40 | C 8 |
| | 12 | 11.7 | 70 | 20 | R 9 | 40 | C 9 |
| Comp. Ex. 8 | 24 | 15.4 | 70 | 20 | R 4 | 40 | C 10 |
| | 48 | 21.8 | 70 | 20 | R 2 | 40 | C 10 |
| | 72 | 28.0 | 70 | 20 | R 2 | 40 | C 10 |

As described thus far, the chemical composition provided by the present invention exhibits optimum performance in removing sidewall polymer or etchant residues produced and remaining from various etching, ashing, and/or ion implantation processes during the photo-processing of semiconductors or liquid crystal display panels. In essence, the chemical composition has several significant advantages when compared to conventional chemical products, which includes but not limited to the followings: The chemical composition does not produce any corrosion or damage to the bottom layer and is economical due to less evaporation loss. The organic solvent contained in the composition also functions as surfactants to easily remove residue on the surface of wafers. The residue cleansing process using the chemical composition does not require separate solvent rinse step essential in conventional photo-processing. Moreover, the eco-friendly chemical composition is virtually non-toxic to the human body and is both applicable in aluminum as well as copper metal processes. The composition is proven to be suitable for application in manufacturing of highly condensed semiconductor circuitry.

The test examples of the present invention are presented below to provide better depictions of the present invention. However, the scope of the present invention is not restricted to the above examples and the originator of the present invention claims the rights to freely improve and modify the present invention within the technological realm of the present invention.

## Claims

1. A chemical composition for removing sidewall polymer or etchant residues produced and remaining from various etching, ashing and/or ion implantation processes during photo-processes of semiconductors, and denaturalized photo-sensitive metallic residues etched from a bottom metal layer, the chemical composition comprising:
at least one organic acid forming coordinate bond with metals, wherein the organic acid is represented by following chemical formula (I) and (II), 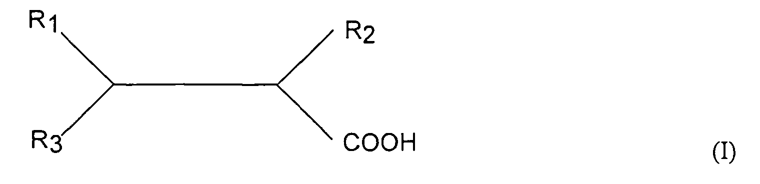 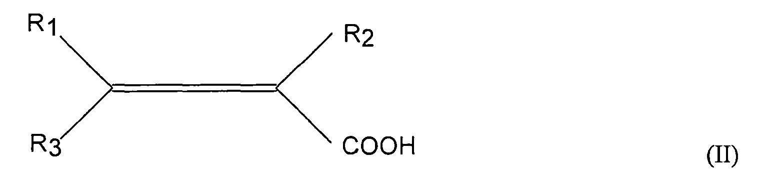
and R1, R2 and R3 is independently selected from a group consisted of hydrogen, alkyl, -OH(hydroxyl) and -COOH(carboxy) groups, and if the R3 is selected from -COOH group, the R3 forms anhydride with -COOH group among the No. 1 carbon atom;
a polar organic solvent represented by RₙO(CH₂CH₂O)ₘH, wherein n and m is independently a constant of 2 to 10;
an additional acid including oxalic acid or inorganic acid; and
de-ionized water.

2. The chemical composition as claimed in claim 1, the organic acid is selected from a group consisted of tartaric acid, citraconic acid, citraconic anhydride, maleic acid (cis type), maleic anhydride and fumaric acid, the organic acied is used in a range between 3.00 to 9.99%, the polar organic solvent includes at least one solvent selected from a group consisted of methyl carbitol (MDG), ethyl carbitol (EDG), butyl carbitol (BDG), dimethyl carbitol (DMDG) and dibutyl carbitol (DBDG), and the inorganic acid is selected from a group consisted of sulfuric acid, perchloric acid and fluoric acid.

3. The chemical composition as claimed in claim 2, the chemical composition is composed of 3.00 to 9.99wt% of the organic acid, 65.00 to 85.7wt% of the polar organic solvent, 0.05 to 0.50wt% of the additional acid and de-ionized water.

4. A chemical composition for removing residues generated in processes for forming semiconductors, the chemical composition comprising:
at least one organic acid forming coordinate bond with metals, wherein the organic acid is represented by following chemical formula (I) and (II), 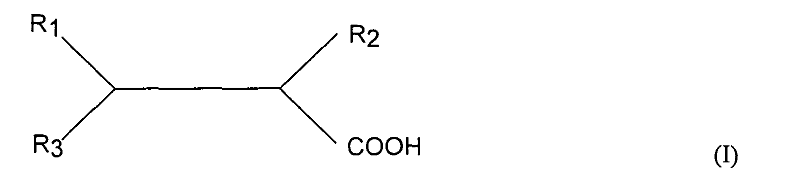 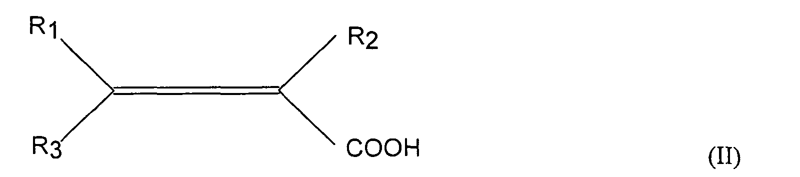
and wherein, R1, R2 and R3 is independently selected from a group consisted of hydrogen, alkyl, -OH(hydroxyl) and -COOH(carboxy) groups, and if the R3 is selected from -COOH group, the R3 forms anhydride with -COOH group among the No. 1 carbon atom;
a polar organic solvent represented by RₙO(CH₂CH₂O)ₘH, wherein n and m is independently a constant of 2 to 10;
an additional acid including oxalic acid or inorganic acid; and
de-ionized water.

5. The chemical composition as claimed in claim 4, the residues include sidewall polymer or etchant residues produced and remaining from various etching, ashing and/or ion implantation processes during photo-processes of semiconductors, and denaturalized photo-sensitive metallic residue etched from a bottom metal layer.

6. The chemical composition as claimed in claim 4, wherein the organic acid is selected from a group consisted of tartaric acid, citraconic acid, citraconic anhydride, maleic acid (cis type), maleic anhydride and fumaric acid.

7. The chemical composition as claimed in claim 4, wherein the organic acied is used in a range between 3.00 to 9.99%.

8. The chemical composition as claimed in claim 4, wherein the polar organic solvent includes at least one solvent selected from a group consisted of methyl carbitol (MDG), ethyl carbitol (EDG), butyl carbitol (BDG), dimethyl carbitol (DMDG) and dibutyl carbitol (DBDG).

9. The chemical composition as claimed in claim 4, wherein the inorganic acid is selected from a group consisted of sulfuric acid, perchloric acid and fluoric acid.

10. The chemical composition as claimed in claim 4, wherein the chemical composition is composed of 3.00 to 9.99wt% of the organic acid, 65.00 to 85.7wt% of the polar organic solvent, 0.05 to 0.50wt% of the additional acids and de-ionized water filling rest portion.
